# EUROPEAN PATENT SPECIFICATION

(11) **EP 0 498 993 B1**
(45) Date of publication and mention of the grant of the patent: **28.01.1998**
(21) Application number: 91310880.9
(22) Date of filing: 26.11.1991
(51) Int. Cl.: H01L 29/812

(54) **Field effect transistor and production method therefor**
Feldeffekttransistor und Verfahren zur Herstellung
Transistor à effet de champ et sa méthode de production

(30) Priority: 28.11.1990 JP 335833/90
(43) Date of publication of application: 19.08.1992
(73) Proprietor: MITSUBISHI DENKI KABUSHIKI KAISHA, Tokyo (JP)
(72) Inventor: Kohno, Yasutaka, c/o Mitsubishi Denki K. K., Itami-shi, Hyogo-ken (JP)
(74) Representative: Beresford, Keith Denis Lewis

(56) References cited:
- EP-A- 0 469 606
- PATENT ABSTRACTS OF JAPAN vol. 14, no. 437 (E-980) 19 September 1990 ; & JP-A-2 170 417
- PATENT ABSTRACTS OF JAPAN vol. 15, no. 442 (E-1131) 11 November 1991 ; & JP-A-3 185 843
- IEEE TRANSACTIONS ON ELECTRON DEVICES, vol. ED-27, no. 6, June 1980, pp. 1013-1018
- IEEE MTT-S INTERNATIONAL MICROWAVE SYMPOSIUM DIGEST, 1990, pp. 1257-1260

## Description

The present invention relates to a field effect transistor and a production method therefor and, more particularly, to a field effect transistor having a structure that enhances a gate-drain breakdown voltage and a production method therefor.

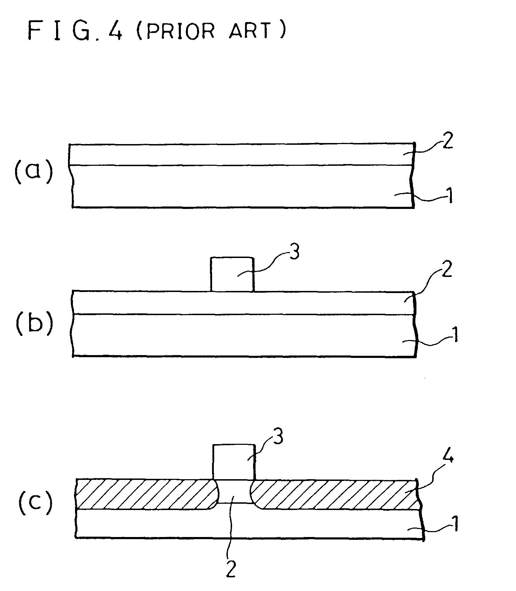

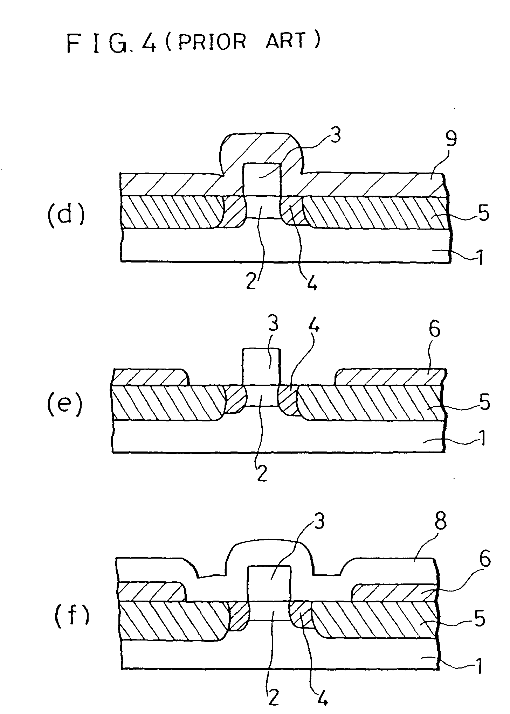

Figures 4(a) to 4(f) are cross-sectional side views illustrating process steps in a prior art method for producing a self-aligned field effect transistor having a refractory metal gate. In the figures, reference numeral 1 designates a semi-insulating GaAs substrate. An active layer 2 is produced in the GaAs substrate 1. A gate electrode 3 made of refractory metal such as tungsten silicide is disposed on the active layer 2. An intermediate dopant concentration region (hereinafter referred to as n' type diffusion layer) 4 is disposed at both sides of the gate electrode 3 in the active layer 2. A high dopant concentration region (hereinafter referred to as n⁺ type diffusion layer) 5 is disposed outside the n' type diffusion layer 4. Ohmic electrodes 6 are disposed on the n⁺ type diffusion layer 5. An insulating film 8 is produced on the entire surface of the substrate 1. The structure of the field effect transistor of figure 4 is well known as LDD(lightly doped drain) structure.

The production method is known from K Hosogi et al, "Super Low-Noise Self-Aligned Gate GaAs MESFET with Noise Figure of 0.87dB at 12GHz" 1990 IEEE MTT-S DIGEST, pp1257 to 1260.

As shown in figure 4(a), Si ions are implanted into a semi-insulating GaAs substrate 1 with a condition of 40 keV and 3.3 × 10¹² cm⁻² to produce an active layer 2.

Next, tungsten silicide (WSi) is deposited on the entire surface of wafer by sputtering. A mask pattern (not shown) of photoresist is formed using photolithography technique. The WSi is removed by reactive ion etching using the mask pattern, thereby producing the WSi gate electrode 3, as shown in figure 4(b).

Next, as shown in figure 4(c), silicon ions are implanted into the active layer 2 with a condition of 50 keV and 1 × 10¹²cm⁻² using the WSi gate electrode 3 as a mask, thereby producing the n' type diffusion layer 4.

Next, as shown in figure 4(d), a SiON film 9 is deposited on the entire surface of the wafer to a thickness of about 2000 angstroms by chemical vapor deposition (CVD). Ion implantation of Si ions is carried out through the SiON film 9 with a condition of 180 keV and 3 × 10¹²cm⁻² and annealing is carried out at a temperature of 800 °C for 15 minutes, thereby producing an n⁺ type diffusion layer 5.

Next, as shown in figure 4(e), metal of AuGe/Ni/Au is deposited on the n⁺ type diffusion layer 5 by lift-off, thereby producing the two ohmic electrodes 6.

An insulating film 8 which is to be a passivation film is deposited on the entire surface of the wafer, thereby completing a semiconductor device having an LDD structure as shown in figure 4(f).

In the prior art field effect transistor, the above-described n' type diffusion layer 4 is an intermediate dopant concentration region formed between the n⁺ diffusion layer 5 and the active layer 2, for moderating an electric field which is concentrated on a region between gate and drain and enhancing a gate-drain breakdown voltage.

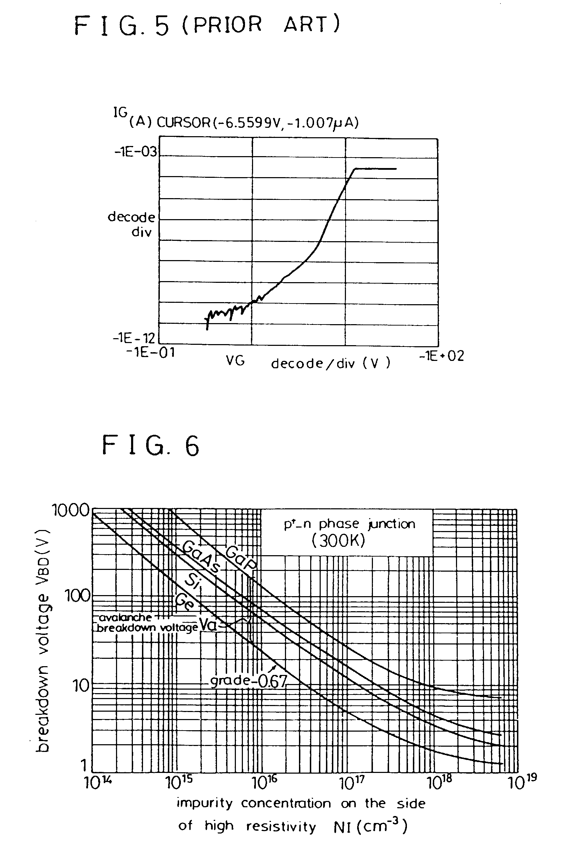

Figure 5 shows a gate-drain breakdown voltage characteristic in the above-described structure. It is found from figure 5 that the bias voltage is approximately 6.6 V when a reverse direction gate current is about 1 µA.

Herein, the gate length and the gate width of this field effect transistor are, respectively, 1 micron and 10 microns.

In the prior art field effect transistor produced by the above-described production method, the dopant concentration of the n' type diffusion layer 4 at drain side is required to be lowered in order to enhance the gate-drain breakdown voltage. In the prior art method, however, the dopant concentration of the n' type diffusion layer at source side is lowered at the same time, thereby increasing the source resistance, resulting in deteriorating the performance of the field effect transistor. Thus, the gate-drain breakdown voltage is under a limitation of approximately 7 V. This makes it impossible to apply this structure to high power analog integrated circuits.

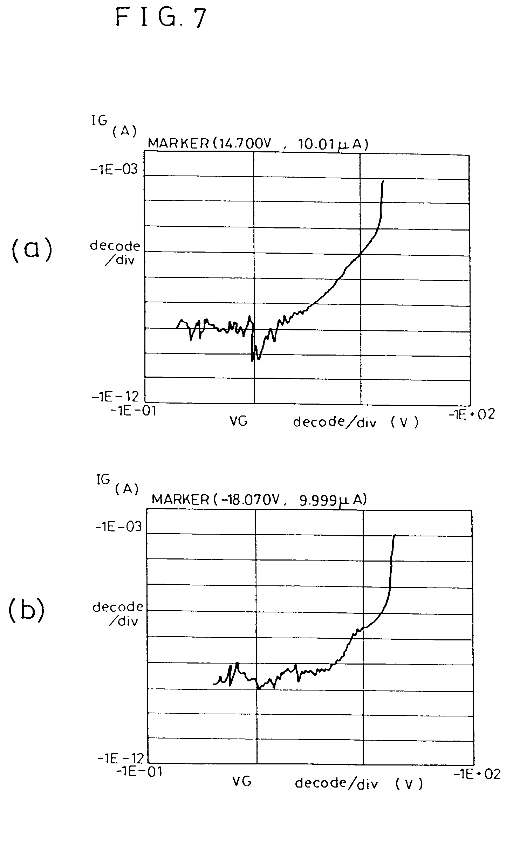

The gate-drain breakdown voltage of a field effect transistor, for example a Schottky barrier type field effect transistor, is determined dependent on the maximum electric field of the Schottky barrier. The maximum electric field of the barrier positions probably in the extreme vicinity of the Schottky metal/GaAs interface and it positions in the vicinity of the gate edge at drain side in a planar type field effect transistor. When a Schottky junction or a pn junction is used in a semiconductor substrate having an impurity concentration uniform in the bulk, the gate-drain breakdown voltage (destruction voltage) depends on the impurity concentration. The relation between the breakdown voltage and the impurity concentration is shown in figure 6. In a usual field effect transistor utilizing GaAs, the surface impurity concentration of an active layer is about 10¹⁷/ cm³ and the gate-drain breakdown voltage is approximately 17 V as shown in figure 6. According to this theory, the above-described self-aligned field effect transistor is thought to have a gate-drain breakdown voltage which is a little lower than 17 V with paying considerations on that the field effect transistor has a planar structure and the distribution of impurity concentration is not uniform. However, the breakdown voltage of the field effect transistor less than 7 V is too low.

To solve the above-described problems, an off-set gate type field effect transistor in which a gate electrode is asymmetrically produced is proposed. However, no enhancement in the yield can be obtained due to that it requires a complicated production process and also due to low reproducibility caused by such as imprecision of alignment.

### SUMMARY OF THE INVENTION

It is an object of the present invention to provide a self-aligned type field effect transistor that has an enhanced gate-drain breakdown voltage without lowering the yield.

It is another object of the present invention to provide a method for producing the above-described self-aligned type field effect transistor.

Other objects and advantages of the present invention will become apparent from the detailed description given hereinafter. It should be understood, however, that the detailed description and specific embodiment are given by way of illustration only, since various changes and modifications within the scope of the invention defined in the claims will become apparent to those skilled in the art from this detailed description.

There are several reports on the methods for stabilizing the surface of GaAs and for lowering the surface levels. For example, one is that a technique that a substrate surface is stabilized by producing such as a sulfurized layer on the crystal interface of semiconductor material is applied to an MIS structure, or a diode, photodiode, and bipolar structure, as is recited in Japanese Published Patent Application No.64-8613.

In addition, "Inst. Phys. Ser. No.74 Chapter 7, Int. Synp. GaAs and Related Compounds, Biarritz 1984" reports that the trapping level in the vicinity of the surface should arise an electric field concentration on the surface and lower the breakdown voltage.

While conducting a research in reference to the literatures as described above, the inventor of the present invention perceived that the gate-drain breakdown voltage is determined dependent on the surface condition of GaAs substrate between source and drain rather than on the impurity concentration of the substrate.

The invention relates to field effect transistor as it is generally known in the art and provides a field effect transistor and methods of manufacture as defined in the appended claims.

In summary a layer for reducing the surface states formed on the surface of the substrate is provided between the gate and the drain electrodes. This construction reduces a large gap of surface states and relieves a concentration of electric field generated on the surface of substrate between the gate and the drain electrodes. It is noted that JP-A-2170417 proposes sulfurisation to reduce surface states at regions where ohmic contacts are to be formed on the substrate surface.

### BRIEF DESCRIPTION OF THE DRAWINGS

Figure 1 is a cross-sectional side view illustrating a field effect transistor in accordance with an embodiment of the present invention;
Figures 2(a) to 2(f) are cross-sectional side views illustrating the process steps of a method for producing a field effect transistor in accordance with an embodiment of the present invention;
Figure 3 is a diagram showing the gate-drain breakdown voltage characteristic of the field effect transistor in accordance with an embodiment of the present invention;
Figures 4(a) to 4(f) are cross-sectional side views illustrating the process steps of a prior art method for producing a field effect transistor;
Figure 5 is a diagram showing the gate-drain breakdown voltage characteristic of a prior art field effect transistor;
Figure 6 is a diagram showing the dependency of the breakdown voltage upon the impurity concentration in GaAs;
Figures 7(a) and 7(b) are diagrams showing the gate-drain breakdown voltage characteristic of the prior art recess type field effect transistor and a recess type field effect transistor in accordance with the present invention, respectively.

### DETAILED DESCRIPTION OF THE PREFERRED EMBODIMENT

An embodiment of the present invention will be described in detail with reference to the drawings.

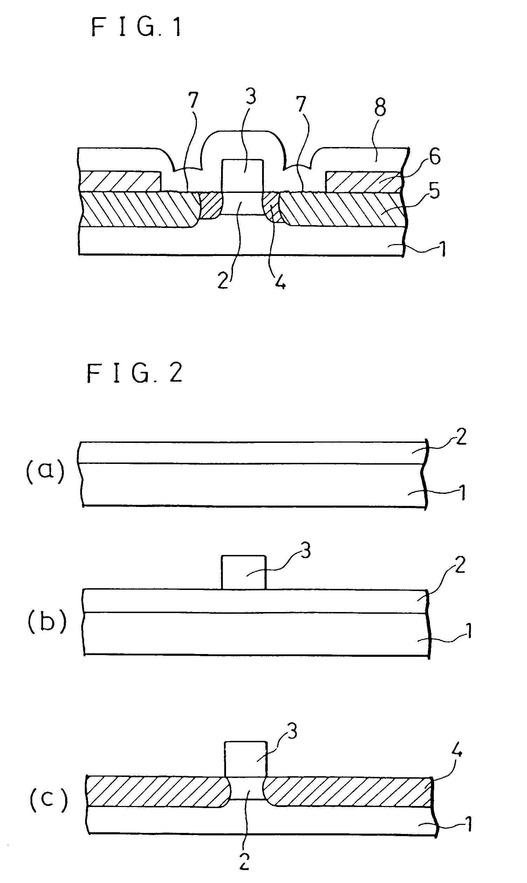

Figure 1 is a cross-sectional view illustrating a field effect transistor according to an embodiment of the present invention. In figure 1, the same reference numerals as those of figure 4 designate the same or corresponding portions. Reference numeral 7 designates a layer for reducing the surface states, which is formed by sulfurizing the surface of the GaAs substrate 1 between the gate electrode 3 and the ohmic electrode 6.

Next, a description will be given of the production process.

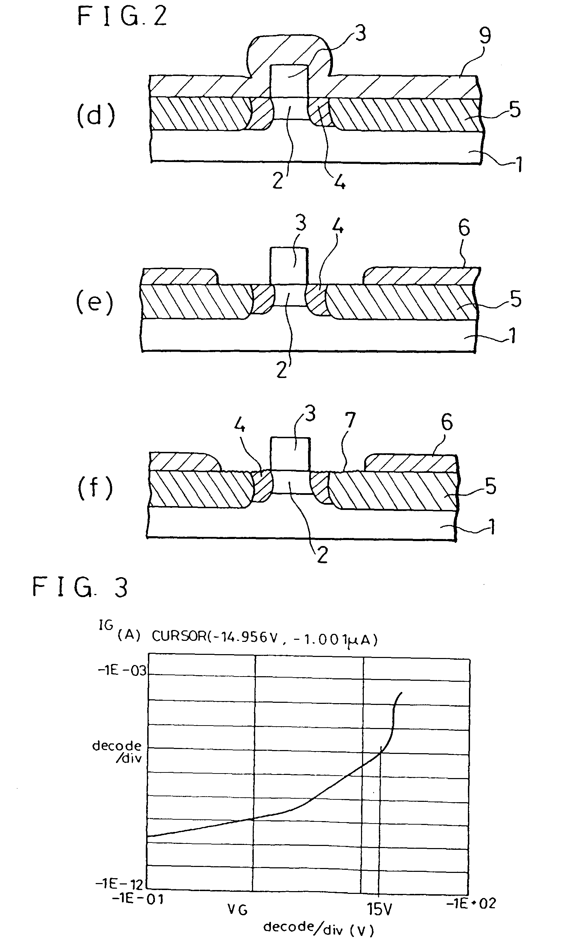

Figures 2(a) to 2(f) are cross-sectional views illustrating process steps for producing a field effect transistor according to an embodiment of the present invention.

Since the process steps shown in figures 2(a) to 2(e) are the same as those of figures 4(a) to 4(e), a description is omitted.

Subsequent to the process of figure 2(e), as shown in figure 2(f), the wafer is dipped in aqueous solution of ammonium sulfide ((NH₄)₂S, (NH₄)₂Sₓ) or aqueous solution of lithium sulfide or aqueous solution of sodium sulfide for 15 minutes to sulfurize the surface of the GaAs substrate 1 between the gate and the drain electrodes and between the gate and the source electrodes, thereby producing the layer for reducing the surface states 7.

Lastly, a passivation film is formed by depositing the insulating film(SiO) 8 on the entire surface of the wafer, thereby completing the semiconductor device of figure 1.

In the MESFET of the present invention, the WSi gate electrode 3 and the ohmic electrodes 6 are produced on the GaAs substrate 1 with the WSi gate electrode 3 disposed between the two ohmic electrodes 6, and the surfaces of the substrate 1 between the gate electrode 3 and the two ohmic electrodes 6 are sulfurized by aqueous solution containing sulfur (S) such as (NH₄)₂S aqueous solution. Therefore, localized levels on the surface of the substrate 1 between the gate electrode 3 and the ohmic electrode 6 are reduced and as shown in figure 3, a bias voltage when a reverse direction gate current is about 1 µA becomes approximately 15.0 V. Accordingly, a field effect transistor having a high gate-drain breakdown voltage can be produced without deteriorating the yield.

While in the above-described embodiment sulfurization is carried out after producing the ohmic electrode 6, the sulfurization may be carried out before producing the ohmic electrode 6. In addition, the region to be sulfurized may be only a region between the gate electrode and the drain electrode.

While in the above-described embodiment a self-aligned field effect transistor having a refractory metal gate is employed, a recess type MESFET can be employed. In this case, as shown in figure 7(b), the recess type MESFET has a gate-drain breakdown voltage of approximately 18.0 V when a reverse direction gate current is about 10 µA. This shows an enhancement with relative that the gate-drain breakdown voltage of approximately 15 V is obtained when a reverse direction gate current is about 10 µA in the prior art recess type MESFET as shown in figure 7(a). Here, the gate width is 100 microns.

While in the above described embodiment aqueous solution of (NH₄)₂S, lithium sulfide, or sodium sulfide is used for sulfurizing the substrate surface, H₂S gas may be used. As well, the layer for reducing the surface states 7 can be formed by a surface treatment using compounds such as Te, P, and Se.

As is evident from the foregoing description, according to the present invention, a field effect transistor comprises a compound semiconductor substrate, a source and a drain electrodes disposed on the compound semiconductor substrate, a gate electrode disposed therebetween, a layer for reducing the surface states formed on the surface of the substrate between the gate electrode and the drain electrodes to reduce localized surface levels at that region. Accordingly, recombination of carriers and energy barrier are reduced between the gate and the drain electrodes and an improved field effect transistor having a high gate-drain breakdown voltage can be obtained without lowering the yield. Therefore, a self-aligned MESFET can be applied to high output analog integrated circuit.

## Claims

1. A field effect transistor comprising:
a compound semiconductor substrate (1) having source and drain regions formed therein;
an active layer (2) formed between said source and drain regions;
a source electrode and a drain electrode (6) disposed on said source and drain regions; and
a gate electrode (3) disposed on said compound semiconductor substrate between said source and drain electrodes;
characterised in that the transistor further comprises a layer (7) for reducing the surface states formed on the surface of said substrate, at least between said gate electrode and said drain electrode, so as to reduce localised surface levels which exist at that region.

2. The field effect transistor of claim 1 wherein said layer for reducing surface levels is a sulphurised layer.

3. A method for producing a field effect transistor comprising a source electrode and a drain electrode disposed on a compound semiconductor substrate and a gate electrode disposed on said compound semiconductor substrate between said source and said drain electrodes, comprising steps of:
producing the gate electrode on an active layer, the active layer having been produced by ion implantation to said semiconductor substrate;
producing a source and a drain region by implanting impurities into the active layer using said gate electrode as a mask;
producing ohmic electrodes on said source and said drain regions of said substrate to form the source and drain electrodes;
producing at the surface of the substrate a layer for reducing localised substrate levels by treating the surface of said surface at least between one of said ohmic electrodes and said gate electrode using a predetermined reactive solution or reactive gas; and
producing a protecting film on the entire surface of the wafer.

4. The method of claim 3 wherein said predetermined reactive solution or reactive gas is a solution or gas containing sulphur.

5. A method for producing a field effect transistor comprising a source electrode and a drain electrode disposed on a compound semiconductor substrate and a gate electrode disposed on said compound semiconductor substrate between said source and said drain electrodes, comprising steps of:
producing the gate electrode on an active layer, the active layer having been produced by ion implantation into said semiconductor substrate;
producing a source and a drain region by implanting impurities into the active layer using said gate electrode as a mask;
producing at the surface of the substrate a layer for reducing localized surface levels by treating the surface of said substrate using a predetermined reactive solution or reactive gas;
producing ohmic electrodes on said source and drain regions of said substrate to form the source and drain electrodes; and
producing a protecting film on the entire surface of the wafer, while the layer for reducing localised surface levels remains on the surface of said substrate at least between said gate electrode and the ohmic electrode of said drain region.

6. The method of claim 5 wherein said predetermined reactive solution or reactive gas is a solution or gas containing sulphur.

## Patentansprüche

1. Feldeffekttransistor mit:
einem Verbindungshalbleitersubstrat (1), welches darin gebildete Source- und Draingebiete aufweist;
einer aktiven Schicht (2), welche zwischen den Source- und Draingebieten gebildet ist;
einer Sourceelektrode und einer Gateelektrode (6), welche auf den Source- und Draingebieten angeordnet sind; und
einer Gateelektrode (3), welche auf dem Verbindungshalbleitersubstrat zwischen den Source- und Drainelektroden angeordnet ist;
dadurch gekennzeichnet, daß der Transistor des weiteren eine Schicht (7) zum Verringern der auf der Oberfläche des Substrats gebildeten Oberflächenzustände wenigstens zwischen der Gateelektrode und der Drainelektrode aufweist, so daß lokalisierte Oberflächenniveaus verringert werden, welche in dem Gebiet vorhanden sind.

2. Feldeffekttransistor nach Anspruch 1, dadurch gekennzeichnet, daß die Schicht zur Verringerung von Oberflächenniveaus eine geschwelfelte Schicht ist.

3. Verfahren zur Herstellung eines Feldeffekttransistors, welcher eine Sourceelektrode und eine Drainelektrode, die auf einem Verbindungshalbleitersubstrat angeordnet sind, und eine Gateelektrode aufweist, die auf dem Verbindungshalbleitersubstrat zwischen den Source- und Drainelektroden angeordnet ist, mit den Schritten:
Erzeugen der Gateelektrode auf einer aktiven Schicht, wobei die aktive Schicht durch Ionenimplantierung in das Halbleitersubstrat erzeugt wird;
Erzeugen eines Source- und eines Draingebiets durch Implantieren von Verunreinigungen in die aktive Schicht unter Verwendung der Gateelektrode als Maske;
Erzeugen von ohmschen Elektroden auf den Source- und Draingebieten des Substrats, um die Source- und Drainelektroden zu bilden;
Erzeugen einer Schicht zur Verringerung von lokalisierten Substratniveaus an der Oberfläche des Substrats durch Behandeln der Oberfläche des Substrats wenigstens zwischen einer der ohmschen Elektroden und der Gateelektrode unter Verwendung einer vorbestimmten reaktiven Lösung oder eines reaktiven Gases; und
Erzeugen einer Schutzschicht auf der gesamten Oberfläche des Wafers.

4. Verfahren nach Anspruch 3, dadurch gekennzeichnet, daß die vorbestimmte reaktive Lösung oder das reaktive Gas eine Lösung oder ein Gas ist, welche Schwefel enthalten.

5. Verfahren zur Herstellung eines Feldeffekttransistors, welcher eine Sourceelektrode und eine Drainelektrode, die auf einem Verbindungshalbleitersubstrat angeordnet sind, und eine Gateelektrode aufweist, die auf dem Verbindungshalbleitersubstrat zwischen den Source- und Drainelektroden angeordnet ist, mit den Schritten:
Erzeugen der Gateelektrode auf der aktiven Schicht, wobei die aktive Schicht durch Ionenimplantierung in das Halbleitersubstrat erzeugt wird;
Erzeugen eines Source- und eines Draingebiets durch Implantieren von Verunreinigungen in die aktive Schicht unter Verwendung der Gateelektrode als Maske;
Erzeugen einer Schicht zum Verringern von lokalisierten Oberflächenniveaus an der Oberfläche des Substrats durch Behandeln der Oberfläche des Substrats unter Verwendung einer vorbestimmten reaktiven Lösung oder eines reaktiven Gases;
Erzeugen von ohmschen Elektroden auf den Source- und Draingebieten des Substrats, um Source- und Drainelektroden zu bilden; und
Erzeugen einer Schutzschicht auf der gesamten Oberfläche des Wafers, während die Schicht zur Verringerung von lokalisierten Oberflächenniveaus auf der Oberfläche des Substrats wenigstens zwischen der Gateelektrode und der ohmschen Elektrode des Draingebiets verbleibt.

6. Verfahren nach Anspruch 5, dadurch gekennzeichnet, daß die vorbestimmte reaktive Lösung oder das reaktive Gas eine Lösung oder ein Gas ist, welche Schwefel enthalten.

## Revendications

1. Un transistor à effet de champ comprenant :
un substrat semi-conducteur composé (1) ayant des régions de source et de drain formées dans celui-ci ;
une couche active (2) formée entre lesdites régions de source et de drain ;
une électrode de source et une électrode de drain (6) disposées sur lesdites régions de source et de drain ; et
une électrode de grille (3) disposée sur le substrat semi-conducteur composé entre lesdits électrodes de source et de drain ;
caractérisé en ce que le transistor comprend de plus une couche (7) pour réduire les états de surface formés sur la surface dudit substrat, au moins entre ladite électrode de grille et ladite électrode de drain, afin de réduire un niveau de surface localisé qui existe à cette région.

2. Le transistor à effet de champ de la revendication 1 dans lequel la couche précitée pour réduire des niveaux de surface est une couche sulfurisée.

3. Un procédé pour produire un transistor à effet de champ comprenant une électrode de source et une électrode de drain disposées sur un substrat à semi-conducteur composé et une électrode de grille disposée sur ledit substrat semi-conducteur composé entre lesdites électrodes de source et de drain, comprenant les étapes de :
produire l'électrode de grille sur une couche active, la couche active ayant été produite par une implantation d'ions audit substrat semi-conducteur ;
produire une région de source et de drain en implantant des impuretés dans la couche active en utilisant ladite électrode de grille comme masque ;
produire des électrodes ohmiques sur lesdites régions de source et de drain dudit substrat pour former les électrodes de source et de drain ;
produire à la surface du substrat une couche pour réduire des niveaux de substrat localisés en traitant la surface de ladite surface au moins entre l'une desdites électrodes ohmiques et ladite électrode de grille en utilisant une solution réactive ou un gaz réactif prédéterminé ; et
produire un film de protection sur toute la surface de la pastille.

4. Le procédé de la revendication 3 dans lequel la solution réactive ou le gaz réactif prédéterminés est une solution ou un gaz contenant du soufre.

5. Un procédé pour produire un transistor à effet de champ comprenant une électrode de source et une électrode de drain disposées sur un substrat semi-conducteur composé et une électrode de grille disposée sur ledit substrat semi-conducteur composé entre lesdits électrodes de source et de drain, comprenant les étapes de :
produire l'électrode de grille sur une couche active, la couche active ayant été produite par implantation d'ions dans ledit substrat semi-conducteur ;
produire une région de source et de drain en implantant les impuretés dans la couche active en utilisant ladite électrode de grille comme masque ;
produire à la surface du substrat une couche pour réduire des niveaux de surface localisés en traitant la surface dudit substrat en utilisant une solution réactive ou un gaz réactif prédéterminé ;
produire des électrodes ohmiques sur lesdites régions de source et de drain dudit substrat pour former les électrodes de source et de drain ; et
produire un film de protection sur toute la surface de la pastille, tandis que la couche pour réduire des niveaux de surface localisés reste sur la surface dudit substrat au moins entre ladite électrode de grille et l'électrode ohmique de ladite région de drain.

6. Le procédé de la revendication 5 dans lequel la solution réactive ou le gaz réactif prédéterminé est une solution ou un gaz contenant du soufre.
